# EUROPÄISCHE PATENTSCHRIFT

(11) **EP 3 167 480 B1**
(45) Veröffentlichungstag und Bekanntmachung des Hinweises auf die Patenterteilung: **12.09.2018**
(21) Anmeldenummer: 15716463.3
(22) Anmeldetag: 02.04.2015
(51) Int. Cl.: H05K 7/20, H05K 1/02, H01L 23/373, H01L 23/473, F28F 3/12, F28F 21/08, F28F 13/00

(54) **KÜHLVORRICHTUNG, VERFAHREN ZUR HERSTELLUNG EINER KÜHLVORRICHTUNG UND LEISTUNGSSCHALTUNG**
COOLING DEVICE, METHOD FOR PRODUCING A COOLING DEVICE AND POWER CIRCUIT
DISPOSITIF DE REFROIDISSEMENT, PROCÉDÉ DE PRODUCTION D'UN DISPOSITIF DE REFROIDISSEMENT ET CIRCUIT DE PUISSANCE

(30) Priorität: 10.07.2014 DE 102014213490
(43) Veröffentlichungstag der Anmeldung: 17.05.2017
(73) Patentinhaber: Continental Automotive GmbH, 30165 Hannover (DE)
(72) Erfinder: SMIT, Arnoud, 90482 Nürnberg (DE); SCHMID, Thomas, 93051 Regensburg (DE); KELLER, Lars, 94330 Alterhofen (DE); RITTSTIEG, Soeren, 93073 Neutraubling (DE)
(86) Internationale Anmeldenummer: PCT/EP2015/057295
(87) Internationale Veröffentlichungsnummer: WO 2016/005065

(56) Entgegenhaltungen:
- EP-A1- 1 372 368
- EP-A1- 1 696 526
- WO-A1-2007/036963
- CN-U- 203 689 311
- CN-Y- 200 968 797
- DE-A1-102012 107 570
- US-A- 4 702 969
- US-A1- 2005 022 978

## Beschreibung

Die Erfindung betrifft eine Kühlvorrichtung, ein Verfahren zur Herstellung der Kühlvorrichtung und eine Leistungsschaltung, die mit einer Kühlvorrichtung ausgestattet ist.

Insbesondere bei Automobilanwendungen werden elektrische oder elektronische Schaltungen bzw. Leistungshalbleiter oder andere elektronische oder elektrische Komponenten verwendet, deren Verlustwärme im Betrieb durch Kühlkörper abgeführt werden muss. Üblicherweise sind die Kühlkörper aus Aluminium wegen der guten Wärmeleitungseigenschaften, während die Schaltung mittels kupferbasierten Leiterplatte oder vergleichbaren Trägern ausgebildet ist. Um eine gute Wärmeübertragung zu gewährleisten, sind die Kupferschichten flächig auf den Aluminiumkühlkörpern befestigt. Aufgrund der unterschiedlichen Wärmeausdehnungskoeffizienten kommt es bei Temperaturzyklen zu Ablöseerscheinungen, die die Lebensdauer und Verlässlichkeit negativ beeinflussen.

US 2005/022978 A1 beschreibt einen flüssigkeitsbasierten Wärmetauscher aus Aluminium.

EP 16 96 526 A1 schlägt eine Nickel-Beschichtung eines kompletten Aluminiumkühlkörpers vor.

Es ist daher eine Aufgabe der Erfindung, eine Möglichkeit aufzuzeigen, mit der sich gekühlte Schaltungen mit höherer Lebensdauer herstellen lassen.

### Offenbarung der Erfindung

Diese Aufgabe wird erfüllt durch den Gegenstand der unabhängigen Ansprüche. Vorteilhafte Ausführungsformen ergeben sich mit den Merkmalen der abhängigen Ansprüche sowie anhand der vorliegenden Beschreibung.

Es wurde erkannt, dass die mechanischen Spannungen zwischen Aluminiumkühlkörper und Kupferschicht der daran montierten Leiterplatte verantwortlich für Ausfälle sind und dass sich die Verlässlichkeit erhöhen lässt, indem die Spannungen verringert werden. Es wird vorgeschlagen, die mechanischen Spannungen zwischen Kühlkörper und daran anbringbarer Kupferschicht der Leiterplatte zu verringern mittels eines Nickel-Blechstücks, das die Verbindung zwischen diesen beiden Komponenten herstellt bzw. zur Montage der Leiterplatte (bzw. der Kupferschicht) vorgesehen ist. Durch die Verwendung eines Blechstücks (dessen Dicke die Dicke etwa einer galvanisierten Nickelschicht übersteigt) kann entlang der Dicke des Blechstücks Spannung abgebaut werden. Die Dicke des Blechstücks erlaubt eine Verformung in einer Längserstreckungsrichtung des Blechstücks (im Gegensatz zu dünnen Lotvereinfachungsschichten). Das Nickel-Blechstück kann an der mit dem Kühlkörper verbundenen Seite gegenüber der entgegengesetzten Seite des Blechstücks verformt sein, wodurch Spannung aufgenommen und somit auch abgebaut wird. Es werden daher die elastischen Eigenschaften des Nickels verwendet, die das Blechstück entlang seiner Dickenrichtung (d.h. senkrecht zu den Längserstreckungsrichtungen) aufweist. Gleichermaßen bietet die vom Kühlkörper abgewandte Seite des Blechstücks gute Löteigenschaften zur Montage von Kupfer. Das Blechstück ermöglicht daher auch einen Materialübergang.

Es wird daher eine Kühlvorrichtung beschrieben, die einen Aluminiumkühlkörper und mindestens ein Nickel-Blechstück aufweist. Die Kühlvorrichtung ist zur Montage an eine Schaltung, insbesondere an eine Kupferschicht eines Schaltungsaufbaus, eingerichtet. Hierbei bildet das Nickel-Blechstück die (flächige) Wärmeübertragungsschnittstelle in Form einer Befestigungsfläche, auf der die Kupferschicht befestigt wird. Das mindestens eine Nickel-Blechstück ist auf den Aluminiumkühlkörper aufgelötet, insbesondere mittels einer Lotschicht. Diese verbindet das Nickel-Blechstück (direkt) mit dem Aluminiumkühlkörper. Die Lotschicht ist insbesondere eine Hartlotschicht.

Die Kühlvorrichtung weist eine Befestigungsfläche zur Befestigung und zur Wärmeaufnahme auf, die die Funktion einer Wärmeübertragungsschnittstelle hat. Die Befestigungsfläche wird von einer Seite des Nickel-Blechstücks ausgebildet. Diese Seite ist dem Aluminiumkühlkörper (und somit auch der Lotschicht zwischen Blechstück und Kühlkörper abgewandt. Diese Seite ist im Wesentlichen eben, kann jedoch auch an den Verlauf der anzubringenden Leiterplatte angepasst sein. Die Dicke des Nickel-Blechstück ist vorzugsweise an jeder Stelle des Blechstücks im Wesentlichen (d.h. mit einer Toleranz von nicht mehr als +/-1% oder +/- 0,1%) gleich.

An dem Kühlkörper können ein oder mehrere Nickel-Blechstücke befestigt sein (insbesondere mittels Lotschicht). Es können mehrere Nickel-Blechstücke direkt oder mit Abstand zueinander an der Oberfläche des Kühlkörpers befestigt sein. Es können mehrere Nickel-Blechstücke an der gleichen, an unterschiedlichen oder an entgegengesetzten Seiten des Kühlkörpers vorgesehen sein. Insbesondere kann an (zwei) entgegengesetzten (vorzugsweise zueinander parallelen) Seiten des Kühlkörpers jeweils ein Nickel-Blechstück oder jeweils mehrere Nickel-Blechstücke befestigt sein. Wie bereits bemerkt, ist das mindestens eine Nickel-Blechstück stoffschlüssig auf dem Kühlkörper befestigt, insbesondere mittels einer stoff schlüssigen Verbindung wie einer Lotverbindung (d.h. mittels einer Lotschicht). Insbesondere ist der Kühlkörper beidseitig mit zumindest einem Nickel-Blechstück versehen, um beidseitig Leiterplatten bzw. Schaltungen anbringen zu können. Der Kühlkörper ist insbesondere flach und vorzugsweise im Wesentlichen Quaderförmig. Der Kühlkörper kann Kühlfinger aufweisen, um Wärme an der Außenseite des Kühlkörpers und insbesondere an den Kühlfingern an ein umgebendes Wärmemedium (Luft) abzugeben, oder kann einen Kühlkanal aufweisen, der sich durch den Kühlkörper hindurch erstreckt, um Wärme an ein Wärmemedium (Flüssigkeit, insbesondere Öl oder Wasser) abzugeben, dass durch den Kühlkanal strömt.

Der Aluminiumkühlkörper kann aus mehreren Aluminiumblechen ausgebildet sein. Diese sind übereinander gestapelt. Ferner sind diese untereinander verbunden, insbesondere mittels einer Lotschicht, vorzugsweise eine Hartlotschicht. Zumindest ein Aluminiumblech weist Ausnehmungen auf. Das zumindest eine Aluminiumblech, das Ausnehmungen aufweist, ist beidseitig von zwei weiteren der Aluminiumbleche abgedeckt oder ist einseitig von dem Aluminiumblech und auf der anderen Seite von dem Blechstück abgedeckt. Die Ausnehmungen bilden einen Kühlkanal. Die Ausnehmungen erstrecken sich durch die gesamte Dicke des Aluminiumblechs oder nur durch einen Teil des betreffenden Aluminiumblechs. Die Ausnehmung ist etwa in Form einer Nut. Die Ausnehmung führt bis zur Kante des Aluminiumblechs. Die Ausnehmung kann einen mäandernden Längsverlauf haben, wobei sich der Längsverlauf der Ausnehmung in eine und vorzugsweise zwei verschiedene Längserstreckungsrichtungen des Aluminiumblechs erstreckt. Die Ausnehmungen erstrecken sich daher vorzugsweise flächig. Die Ausnehmungen können in eine oder zwei Richtungen gemäß einem Raster ausgebildet sein. Die Ausnehmungen sind beispielsweise gestanzt oder gefräst oder auch gegossen. Die Aluminiumbleche sind insbesondere mittels Lotschichten miteinander verbunden. Die Lotschichten dichten die Aluminiumbleche gegeneinander ab. Zwischen den Aluminiumblechen kann auch ein anderes Dichtelement vorgesehen sein (eine Lage abdichtenden, elastischen Materials wie etwa Silikon), wobei die Aluminiumbleche mittels Befestigungselemente miteinander verbunden sind, etwa eine Schraubverbindung, die sich durch die Aluminiumbleche erstreckt. Eines der Aluminiumbleche kann als flächige oder stabförmige Kühlfinnen aufweisen, die in den Kühlkanal hineinragen. Eine Ausgestaltung mit stabförmigen Kühlfinnen wird auch als "Pin Fin"-Struktur bezeichnet, wobei die Kühlfinnen flächig (und vorzugsweise gleichmäßig) verteilt sind. Die Kühlfinnen erstrecken sich insbesondere im Inneren des Aluminiumkühlkörpers, d.h. in den zumindest einen Kühlkanal hinein, und können somit auch (in funktioneller Hinsicht) als Turbulatoren betrachtet werden.

Die Aluminiumbleche sind insbesondere gewalzte Aluminiumbleche sind, die mittels Hartlot verlötbar sind. Der Kühlkörper und insbesondere die Aluminiumbleche haben vorzugsweise einen Schmelzpunkt von mindestens 590°C, wobei als Hartlot (zur Verbindung der Aluminiumbleche und/oder zur Befestigung des Nickel-Blechstücks, d.h. als Lotschicht) vorzugsweise Aluminium mit 8 - 15 % Massenanteil Silizium verwendet wird. Das Hartlot hat vorzugsweise eine Gießtemperatur von 670 - 740 ° C und ein Erstarrungsintervall von 570 - 590 °C. Es kann insbesondere AlSi12 als Hartlot verwendet werden. Als Hartlot eignen sich alle Al-Legierungen mit einem Silizium-Masseanteil von 7-13%. Zudem kann das Schmelzintervall des Hartlots von 575°C-615°C betragen.

Insbesondere haben der Kühlkörper und insbesondere die Aluminiumbleche einen Magnesiumanteil von weniger als 2 % Massenanteil, wodurch eine gute Benutzbarkeit (mit Lotmaterial) erreicht wird. Der Kühlkörper und insbesondere die Aluminiumbleche weisen einen Massenanteil von mindestens 70% Aluminium auf, um die Korrosionsbeständigkeit zu gewährleisten. Es können gewalzte (oder auch gegossene) Aluminiumbleche verwendet werden, unter anderem auch AlMg5Si2Mn. Die Schmelzuntergrenze der Aluminiumbleche beträgt in diesem Fall beispielsweise 594 °C. Falls der Aluminiumkörper nicht als Aluminiumblechstapel ausgebildet ist, kann dieser aus dem Material sein, aus dem die hier genannten Aluminiumbleche sind. Die vorgehenden Angaben betreffen daher gleichermaßen Aluminiumbleche und der Aluminiumkühlkörper.

Die Begriffe "Aluminiumbleche" und "Aluminiumkühlkörper" weisen den Wortbestandteil "Aluminium" auf, wodurch angegeben wird, dass der Bestandteil vorwiegend Aluminium ist. Daher wird durch die Verwendung des Wortbestandteils "Aluminium" nicht auf einen Aluminiumanteil von 100% (Massenanteil) hingewiesen, sondern es kann sich um eine Legierung handeln, die vorwiegend aus Aluminium besteht, wobei wie erwähnt Zusätze nicht ausgeschlossen sind.

Das mindestens eine Nickel-Blechstück hat einen Massenanteil von Nickel von mindestens 70%, 85% oder auch von mindestens 95%, 98% oder 99% Nickel. Das Nickel-Blechstück kann einen Metallkern und eine Nickelschicht aufweist, die diesen umgibt. Der Massenanteil von Nickel in der Nickelschicht beträgt mindestens 70%, 85% oder auch mindestens 95%, 98% oder 99%. Die Wärmeleitfähigkeit des Nickel-Blechstück beträgt vorzugsweise mindestens 70, 75 und besonders bevorzugt mindestens 85 oder 90 W/m * K. Das Nickel-Blechstück kann einseitig (zum Aluminiumkühlkörper gerichtet) oder beidseitig eine Hartlotschicht aufweisen, bevor diese mit dem Aluminiumkühlkörper bzw. mit dem betreffenden Aluminiumblech verbunden wird. Das Nickel-Blechstück kann zum Aluminiumkühlkörper gerichtet eine Hartlotschicht aufweisen und auf der entgegengesetzten Seite eine Weichlotschicht. Dieses derartig mit mindestens einer Lotschicht (oder einer entsprechenden Lötmasse) versehene Nickel-Blechstück wird zusammen mit dem Aluminiumkühlkörper gestapelt und verlötet (etwa in einem Ofen) .

Das Nickel-Blechstück kann eine Dicke von mindestens 200, 500, 800 µm aufweisen. Insbesondere werden Blechstärken (im Sinne von Feinblechen) von ca. 1 mm oder 1,5 mm verwendet. Das Nickel-Blechstück (und auch das mindestens eine Aluminiumblech) können durch Trennen, insbesondere durch Schneiden oder Stanzen, eines Bands oder eines Streifens des betreffenden Materials erzeugt werden.

In dem Kühlkörper können Kühlkanäle vorgesehen sein, die einen freien Innenquerschnitt aufweisen, oder in denen Turbulatoren eingebracht sind. Die Turbulatoren sind körperlich eigenständige Körper (etwa ein gefaltetes Blechstück), die mit der Innenwand des Kühlkanals verbunden sind, oder werden durch seitliche Ausnehmungen gebildet, oder werden durch Körperabschnitte gebildet, die in den Kanal hineinragen.

Ferner wird ein Verfahren zur Herstellung einer hier beschriebenen Kühlvorrichtung dargelegt. Im Rahmen des Verfahrens wird Lötmasse auf eine Verbindungsfläche mindestens eines Aluminiumblechs aufgebracht, etwa durch Drucken oder Aufwalzen, insbesondere durch Aufbringen oder Einlegen eines "Preforms" als Blech oder Folie, die die Lötmasse (insbesondere die Hartlötmasse innerhalb der Kühlvorrichtung) bildet. Die Aluminiumbleche werden gestapelt. Insbesondere werden die bereits mit Lötmasse versehenen Aluminiumbleche gestapelt oder die Aluminiumbleche werden alternierend mit der als Blech oder Folie ausgebildeten Lötmasse gestapelt. Die Lötmasse wird geschmolzen, um zumindest eine Lotschicht zwischen den Aluminiumblechen auszubilden. Dies wird beispielsweise ausgeführt, indem die Aluminiumbleche zusammen mit der Lötmasse erwärmt werden, etwa in einem Ofen. Der Ofen kann evakuiert sein oder kann im Innenraum eine Stickstoffatmosphäre aufweisen. Dadurch wird der Aluminiumkühlkörper als gestapelte Aluminiumblechstruktur erzeugt. Es kann Flussmittel verwendet werden, insbesondere als Zusatz zu der Lötmasse.

Im Rahmen des Verfahrens wird ferner das mindestens eine Nickel-Blechstück auf eines der Aluminiumbleche aufgelegt, insbesondere auf eines der Aluminiumbleche eine Außenseite des Aluminiumkühlkörpers bilden. Es befindet sich hierbei sich Lötmasse zwischen dem Nickel-Blechstück und dem Aluminiumblech befindet. Daher kann vorgesehen sein, dass auf Verbindungsfläche des Nickel-Blechstücks oder des betreffenden Aluminiumblechs Lötmasse aufgebracht wird.

Die Lötmasse, die sich zwischen dem Nickel-Blechstück und dem Aluminiumblech befindet, wird durch den gleichen Schritt aufgeschmolzen wie die Lötmasse zwischen den Aluminiumblechen. Daher kann die Lötmasse, die sich zwischen dem Nickel-Blechstück und dem Aluminiumblech befindet, und die Lötmasse zwischen den Aluminiumblechen in ein und demselben Schritt erwärmt bzw. aufgeschmolzen werden, etwa indem sich die gestapelten Aluminiumbleche und das mindestens eine Nickel-Blechstück in einen Ofen eingebracht werden, der die Lötmasse erwärmt und dadurch aufschmilzt. Es wird eine Lotschicht zwischen dem Nickel-Blechstück und dem Aluminiumkühlkörper ausgebildet, insbesondere in ein und demselben Schritt des Erwärmens (etwa in einem Ofen).

Vor dem Stapeln kann zumindest eines der Aluminiumbleche gestanzt werden. Durch das Stanzen werden die Ausnehmungen gebildet, die den Kühlkanal bilden, der durch benachbarte Bleche oder Blechstücke abgeschlossen wird. Dieses Aluminiumblech wird im Rahmen des Stapelns zwischen zwei Aluminiumbleche oder zwischen einem Aluminiumbleche und dem Nickel-Blechstück eingefügt. Durch das Stapeln wird mittels der umgebenden Aluminiumbleche (bzw. mittels des umgebenden Aluminiumblechs und des Nickel-Blechstücks) ein Kühlkanal ausgebildet. Durch das Stanzen werden die Ausnehmungen erzeugt, die zusammen mit den benachbarten Komponenten den mindestens einen Kühlkanal ausbilden. Im Rahmen des Stapelns kann ferner ein Turbulator (als eigenständiger Körper) in die Ausnehmung eingelegt und/oder dort befestigt werden. Hierbei kann zwischen dem Turbulator und dem angrenzenden Aluminiumblech oder Nickel-Blechstück Lötmasse eingebracht werden, so dass zusammen mit der Lötmasse zwischen den Aluminiumblechen und der Lötmasse zwischen dem Nickel-Blechstück und einem der Aluminiumbleche auch die Lötmasse zwischen dem Turbulator und dem angrenzenden Blech oder Blechstück aufgeschmolzen wird, um eine Lotschicht zu bilden. Hierbei wird eine Lötmasse auf Hartlot verwendet, insbesondere ein Aluminiumlot mit Siliziumanteil. Die Lötmasse hat vorzugsweise einen Schmelzpunkt von mindestens 450 °C.

In einem nachfolgenden Schritt kann mittels Weichlöten eine Leiterplatte oder ein anderer Träger mit Kupferleitschicht (oder auch nur eine Kupferleitschicht selbst) auf das Nickel-Blechstück aufgelötet werden. Die Temperatur ist hierbei unter dem Schmelzpunkt der vorangehend genannten Lötmasse.

Es wird ferner eine Leistungsschaltung mit einer wie hier erwähnten Kühlvorrichtung mit Aluminiumkühlkörper und Nickel-Blechstück beschrieben, die ferner eine Leiterplatte aufweist. Die Leiterplatte in beidseitig mit einer Leiterschicht versehen, insbesondere eine Kupfer-Leiterschicht. Die Leiterschicht und somit auch die Leiterplatte sind über eine Lotschicht (vorzugsweise Weichlot) mit dem Nickel-Blechstück verbunden, insbesondere mit der Befestigungsfläche, welche von dem Nickel-Blechstück ausgebildet wird. Die Leistungsschaltung weist ferner mindestens einen Halbleiter oder ein anderes elektrisches oder elektronisches Bauteil auf, der bzw. das auf der Seite der Leiterplatte auf der Leiterplatte montiert ist, die dem Nickel-Blechstück abgewandt ist (d.h. auf der entgegengesetzten Leiterschicht). Die Lotschicht zwischen Leiterplatte und Befestigungsfläche bzw. zwischen Bauteil und Leiterplatte ist insbesondere aus Weichlot. Es kann Sn-basierte Weichlot verwendet werden, vorzugsweise mit Ag-Zusatz, insbesondere Weichlot der Gruppe SnAg3,5, alternativ mit den Abwandlungen SnAg3Cu0,5 und Sn95,75Ag3,5Cu0,75.

Der Halbleiter kann ein Leistungshalbleiter in Form eines ungehäusten Halbleiters sein. Dieser ist mittels einer Weichlotschicht auf der Leiterplatte befestigt. Der Halbleiter (bzw. das Bauteil) kann im gleichen Schritt auf der Leiterplatte aufgelötet werden, in dem auch die Leiterplatte auf den die Kühlvorrichtung (bzw. auf den Aluminiumkühlkörper bzw. auf die Befestigungsfläche / das Nickelblechstück) aufgelötet wird, indem die betreffende (Weich-)Lötmasse in einem Ofen (zusammen mit der Kühlvorrichtung, der Leiterplatte und dem Halbleiter/ dem Bauteil) erwärmt wird. In dem Ofen wird dabei eine Temperatur vorgesehen, die über dem Schmelzpunkt der Lötmasse zwischen Bauteil und Leiterplatte und der Lötmasse zwischen der Leiterplatte und dem Kühlkörper liegt, und die unter dem Schmelzpunkt der Lötmasse bzw. der Lotschichten liegt, die sich innerhalb der Kühlvorrichtung befinden.

Die Leistungsschaltung bildet insbesondere eine Elektromotor-Leistungsansteuerung eines Fahrzeugs, einen Spannungs- oder Strom-Leistungswandler in einem Fahrzeugbordnetz oder eine Wechselrichter- oder Gleichrichterschaltung. Die Leistungsschaltung ist vorzugsweise mehrphasig ausgelegt, insbesondere dreiphasig. Als Leistungsschaltung werden insbesondere Schaltungen bezeichnet, die eine Stromtragfähigkeit für Ströme von mindestens 50 A, 100 A, 200 A oder 500 A aufweisen.

Als Leiterplatte werden insbesondere "Direct Copper Bonded"-Leiterplatten verwendet, wobei auch gedruckte Leiterplatten mit Kupferkaschierung möglich sind. Zudem können als Leiterplatten Substrate verwendet werden, bei denen die Leiterschicht zunächst als einzelnes Blech strukturiert wird, wobei sich etwa durch Stanzen einzelne Leiterbahnen bzw. die Verbindungsstruktur ergeben, und danach diese Verbindungsstruktur mit dem Substrat verbunden wird, etwa durch Umspritzen der Verbindungsstruktur mit dem Material des (elektrisch isolierenden) Substrats.

### Kurzbeschreibung der Zeichnung

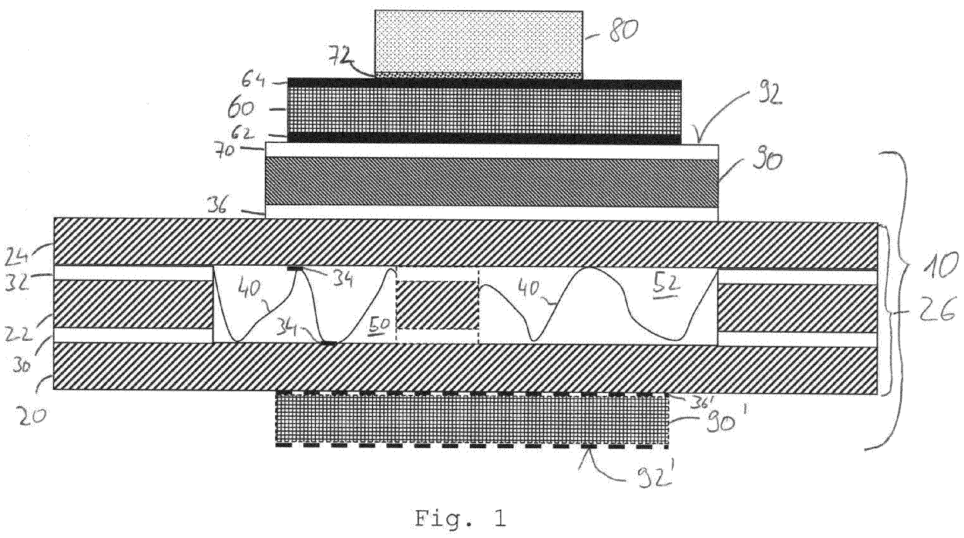

Die Figur 1 zeigt eine Leistungsschaltung und einen der Leistungsschaltung zugehörigen Kühlkörper im Querschnitt.

### Detaillierte Beschreibung der Zeichnung

Figur 1 zeigt im Querschnitt eine Kühlvorrichtung 10, die mehrere, übereinander gestapelte Aluminiumbleche 20, 22, 24 umfasst. Die Aluminiumbleche (einschließlich zugehöriger Elemente wie Lotschichten, Zulauf, Ablauf, Turbulatoren, Befestigungselemente, ...) bilden einen Aluminiumkühlkörper. Die Aluminiumbleche sind bündig übereinander gestapelt. Das Aluminiumblech 22, welches zwischen den Aluminiumblechen 20 und 24 liegt, weist Ausnehmungen 50, 52 auf, die einen Kühlkanal ausbilden. Dieser Kühlkanal reicht bis zu einer Außenfläche des Kühlkörpers 10, insbesondere bis zu einer Kante, die etwa versetzt zur Zeichenebene liegt (und daher nicht dargestellt ist) . Es können ein Zulauf bzw. ein Ablauf vorgesehen sein, die sich an den Enden des Kühlkanals befinden.

Die Aluminiumbleche 20 - 24 sind mittels Lotschichten 30 bzw. 32 miteinander verbunden, wobei zwischen zwei benachbarten Aluminiumblechen jeweils eine Lotschicht liegt. Die Lotschicht befindet sich insbesondere dort, wo die Aluminiumbleche auch aufeinander stoßen, wobei an den Ausnehmungen 50, 52 auch keine Lötmasse bzw. auch keine Lotschicht vorgesehen sein kann. Innerhalb der Ausnehmungen 50, 52 können sich Turbolatoren 40 befinden, die wie dargestellt aus gewelltem Blech ausgebildet sind. Diese sind über einzelne Lotschichtabschnitte 34 mit den angrenzenden Aluminiumblechen 20, 24 verbunden. Die Turbolatoren 50, 52 sind jedoch optional und können auch weggelassen werden. Die Ausnehmungen 50, 52 erstrecken sich durch die gesamte Dicke des zwischenliegenden Aluminiumblechs 22 hindurch. Dadurch bilden die Ausnehmungen 50, 52 gleichermaßen jeweils einen Kühlkanal (oder Kühlkanalabschnitt eines gemeinsamen Kühlkanals), der von den Blechen 20, 24 abgeschlossen ist, zwischen denen das Blech 22 mit den Ausnehmungen liegt.

An einer Außenseite der gestapelten Aluminiumbleche, insbesondere an einer Hauptoberfläche eines außenliegenden Aluminiumblechs 20, 24, welches von den Ausnehmungen 50, 52 abgewandt ist, befindet sich ein Nickel-Blechstück 90, welches über eine Lotschicht 36 mit dem Aluminiumblech 24 verbunden ist. Die Lotschichten 30 - 36 sind Hartlotschichten und können in einem gemeinsamen Schmelzprozess innerhalb eines Ofens erzeugt werden.

Das Nickel-Blechstück 90 bildet eine Befestigungsfläche 92, die den Aluminiumblechen 20 - 24 abgewandt ist. Diese Befestigungsfläche 92 wird gebildet von einer Oberseite des Nickel-Blechstücks 90 und insbesondere von einer mit einer Lotschicht 70 versehenen Oberfläche des Nickel-Blechstücks 90. Die Lotschicht 70 ist insbesondere aus Weichlot. Auf die Befestigungsfläche können zu kühlende elektronische oder elektrische Komponenten befestigt werden.

Die Figur 1 zeigt neben dem erfindungsgemäßen Kühlkörper 10 eine bestückte Leiterplatte 60, die sich auf der Befestigungsfläche 92 befindet. Somit zeigt die Figur 1 neben dem erfindungsgemäßen Kühlkörper 10 auch eine Leistungsschaltung, die den Kühlkörper 10 umfasst und die ferner die Leistungsschaltung ausbildet. Die Leiterplatte 60 ist eine beidseitig beschichtete Leiterplatte mit einer ersten Leiterschicht 62 und einer zweiten Leiterschicht 64. Die erste Leiterschicht 62 ist über die Weichlotschicht 70 mit dem Nickel-Blechstück 70 verbunden, so dass die Leiterplatte 60 über die erste Leiterschicht 62 mit der Befestigungsfläche des Kühlkörpers 10 verbunden ist. Die entgegengesetzte, zweite Leiterschicht 62 dient zur Montage eines Halbleiters 80, der stellvertretend auch für andere elektrische oder elektronische Bauteile steht, insbesondere Leistungsbauteile.

Eine Lotschicht 72, die ebenso wie die Schicht 70 als Weichlotschicht ausgebildet ist, verbindet den Halbleiter 80 mit der zweiten Leiterschicht 64, die den Kühlkörper 10 abgewandt ist. Der Halbleiter 80 ist ein ungehäuster Halbleiter, etwa ein Transistor, insbesondere ein IGBT oder ein MOSFET. Der Halbleiter 80 steht nur beispielhaft für eine Vielzahl von Bauteilen, die auf der Leiterplatte 60 montiert sein können.

Zur besseren Darstellung wurde in Figur 1 die Leiterplatte 60 schmaler als das Nickel-Blechstück dargestellt, wobei in weiteren Ausführungsformen die Leiterplatte über die Lotschicht und auch über den Kühlkörper 10 hinausgehen kann. Hierbei sind insbesondere Leistungshalbleiter oder Leistungsbauteile, die abzuführende Wärme erzeugen, vorzugsweise über der Befestigungsfläche 92 angeordnet, so dass der Wärmeleitpfad für die abzuführende Wärme kurz bleibt.

Weiterhin kann der Kühlkörper 10 nicht nur einseitig ein Nickel-Blechstück 90 und somit eine Befestigungsfläche 92 aufweisen, sondern kann auch beidseitig mit Nickel-Blechstücken versehen sein. Hierbei ist beispielhaft das optionale Nickel-Blechstück 90' dargestellt, welches sich gegenüber dem Nickel-Blechstück 90 auf entgegengesetzter Seite des Aluminiumkörpers (gebildet durch die Aluminiumschichten 20 - 24) befindet. Dieses zweite Nickel-Blechstück 90' eine weitere Befestigungsfläche 92', an der Bauteile oder Leiterplatten befestigt werden können, um deren Wärme abzuführen. Das Nickel-Blechstück 90' ist wie das Nickel-Blechstück 90 mittels einer Hartlotschicht 36' mit dem Aluminiumkühlkörper (d.h. mit den Aluminiumblechen) verbunden. Wie bereits bemerkt wird der Aluminiumkühlkörper von den Aluminiumblechen 20, 22 und 24 sowie den dazwischenliegenden Lotschichten 30 und 32 gebildet, ggf. inklusive der Turbolatoren 40. In weiteren, nicht dargestellten Ausführungsformen kann der Aluminiumkühlkörper auch auf andere Weise als durch gestrichelte Aluminiumbleche dargestellt sein, etwa durch einen durchgehenden Aluminiumkörper oder durch einen Aluminiumkörper, in dem Kühlkanäle eingelassen sind. Neben internen Kühlkanälen kann der Aluminiumkühlkörper auch Kühlfinnen aufweisen, insbesondere an der Oberfläche des Aluminiumkühlkörpers, so dass alternativ oder zusätzlich Wärme über die Oberfläche des Kühlkörpers (und nicht nur über die Kühlkanäle) abgeführt werden kann.

### Bezugszeichenliste

- 10: Kühlvorrichtung
- 20, 22, 24: Aluminiumbleche
- 26: Aluminiumkühlkörper
- 30, 32, 36: Lotschichten, insbesondere Hartlotschichten
- 34: Hartlotschichten zur Befestigung der Turbolatoren
- 40: Turbolatoren
- 50, 52: Ausnehmungen in Aluminiumblech bzw. in Aluminiumkühlkörper 26
- 60: Leiterplatte
- 62, 64: Leiterschichten der Leiterplatte 60
- 70, 72: Lotschichten, insbesondere Weichlotschichten
- 80: Halbleiter, vorzugsweise ungehäust
- 90, 90': Nickel-Blechstück
- 92, 92': Befestigungsfläche

## Patentansprüche

1. Kühlvorrichtung (10), die einen Aluminiumkühlkörper (26) und mindestens ein Nickel-Blechstück (90, 90') aufweist, welches mittels einer Lotschicht (36) mit dem Aluminiumkühlkörper (26) verbunden ist, wobei die Kühlvorrichtung (10) eine Befestigungsfläche (92, 92') zur Befestigung und zur Wärmeaufnahme von mindestens einem Halbleiter oder einem anderen elektrischen oder elektronischen Bauteil aufweist, die von einer Seite des Nickel-Blechstücks (90) ausgebildet wird, die dem Aluminiumkühlkörper (26) abgewandt ist.

2. Kühlvorrichtung nach Anspruch 1, wobei das mindestens eine Nickel-Blechstück (90, 90') mittels der Lotschicht (36) direkt mit dem Aluminiumkühlkörper (26) verbunden ist.

3. Kühlvorrichtung nach Anspruch 1 oder 2, wobei der Aluminiumkühlkörper (26) aus mehreren übereinander gestapelten und miteinander verbundenen Aluminiumblechen (20, 22, 24) ausgebildet ist, wobei zumindest ein Aluminiumblech (22) Ausnehmungen (50) aufweist, die einen Kühlkanal bilden, der von zumindest einem der Aluminiumbleche (20, 24) abgedeckt ist.

4. Kühlvorrichtung nach Anspruch 3, wobei die Aluminiumbleche mittels Lotschichten (30, 32) miteinander verbunden sind.

5. Kühlvorrichtung nach Anspruch 3 oder 4, wobei die Aluminiumbleche (20 - 24) gewalzte Aluminiumbleche sind, die mittels Hartlot verlötbar sind.

6. Kühlvorrichtung nach einem der vorangehenden Ansprüche, wobei das Nickel-Blechstück (90, 90') einen Massenanteil von Nickel von mindestens 70%, 85% und vorzugsweise mindestens 95%, 98% oder 99% Nickel aufweist, oder das Nickel-Blechstück einen Metallkern und eine Nickelschicht aufweist, die diesen umgibt und die einen Massenanteil von Nickel von mindestens 70%, 85% und vorzugsweise von mindestens 95%, 98% oder 99% Nickel aufweist.

7. Kühlvorrichtung nach einem der vorangehenden Ansprüche, wobei das Nickel-Blechstück (90, 90') eine Dicke von mindestens 200, 500 oder 800 µm aufweist.

8. Verfahren zur Herstellung einer Kühlvorrichtung (10) nach Anspruch 1, umfassend:
(a) Aufbringen von Lötmasse auf eine Verbindungsfläche von mindestens einem Aluminiumblech (20, 22, 24);
(b) Stapeln von Aluminiumblechen (20, 22, 24), die das mindestens eine Aluminiumblech umfassen, auf das die Lötmasse aufgebracht wurde;
(c) Schmelzen der Lötmasse, um zumindest eine Lotschicht (30, 32) zwischen den Aluminiumblechen auszubilden, indem die Aluminiumbleche (20, 22, 24) zusammen mit der Lötmasse erwärmt werden, wodurch der Aluminiumkühlkörper (26) als gestapelte Aluminiumblechstruktur erzeugt wird, wobei das Verfahren ferner umfasst:
(d) Anordnen des Nickel-Blechstücks (90, 90') auf eines der Aluminiumbleche (24), das eine Außenseite des Aluminiumkühlkörpers (26) bildet, wobei sich Lötmasse zwischen dem Nickel-Blechstück (90) und dem Aluminiumblech (24) befindet, und wobei die Lötmasse, die sich zwischen dem Nickel-Blechstück (90) und dem Aluminiumblech (24) befindet, durch das Erwärmen des Schritts (c) geschmolzen wird, um eine Lotschicht (36) zwischen dem Nickel-Blechstück (90, 90') und dem Aluminiumkühlkörper (26) auszubilden.

9. Verfahren nach Anspruch 8, wobei vor dem Stapeln zumindest eines der Aluminiumbleche (22) gestanzt wird, um durch das Stapeln mittels der umgebenden Aluminiumbleche (20, 24) einen Kühlkanal auszubilden.

10. Leistungsschaltung mit einem Kühlkörper (10) nach einem der Ansprüche 1-7, wobei die Leistungsschaltung ferner eine Leiterplatte (60) mit beidseitiger Leiterschicht (62, 64) aufweist, die über eine Lotschicht (70) mit dem Nickel-Blechstück (90) verbunden ist, und wobei die Leistungsschaltung ferner mindestens einen Halbleiter (80) aufweist, der auf der Seite der Leiterplatte (60) auf der Leiterplatte (60) montiert ist, die dem Nickel-Blechstück (90) abgewandt ist.

11. Leistungsschaltung nach Anspruch 10, wobei der Halbleiter (80) ein Leistungshalbleiter in Form eines ungehäusten Halbleiters ist, der mittels einer Weichlotschicht (62) auf der Leiterplatte befestigt ist.

## Claims

1. Cooling device (10), which has an aluminum cooling element (26) and at least one nickel metal sheet (90, 90') which is connected to the aluminum cooling element (26) by means of a solder layer (36), wherein the cooling device (10) has a mounting surface (92, 92') for mounting purposes and for absorption of heat from at least one semiconductor or another electrical or electronic component, which is formed by a side of the nickel metal sheet (90) which faces away from the aluminum cooling element (26).

2. Cooling device according to Claim 1, wherein the at least one nickel metal sheet (90, 90') is connected directly to the aluminum cooling element (26) by means of the solder layer (36).

3. Cooling device according to Claim 1 or 2, wherein the aluminum cooling element (26) is formed by a plurality of aluminum sheets (20, 22, 24) which are stacked above one another and connected to one another, wherein at least one aluminum sheet (22) has cutouts (50) which form a cooling channel which is covered by at least one of the aluminum sheets (20, 24).

4. Cooling device according to Claim 3, wherein the aluminum sheets are connected to one another by means of solder layers (30, 32).

5. Cooling device according to Claim 3 or 4, wherein the aluminum sheets (20 - 24) are rolled aluminum sheets, which may be soldered by means of hard solder.

6. Cooling device according to one of the preceding claims, wherein the nickel metal sheet (90, 90') contains at least 70%, 85% and preferably at least 95%, 98% or 99% by mass of nickel, or the nickel metal sheet has a metal core and a nickel layer which surrounds this metal core and which contains at least 70%, 85% and preferably at least 95%, 98% or 99% by mass of nickel.

7. Cooling device according to one of the preceding claims, wherein the nickel metal sheet (90, 90') has a thickness of at least 200, 500 or 800 µm.

8. Method for producing a cooling device (10) according to Claim 1, comprising:
(a) applying solder material to a connecting surface of at least one aluminum sheet (20, 22, 24);
(b) stacking aluminum sheets (20, 22, 24) which comprise the at least one aluminum sheet to which the solder material has been applied;
(c) melting the solder material to form at least one solder layer (30, 32) between the aluminum sheets by heating the aluminum sheets (20, 22, 24) together with the solder material, whereby the aluminum cooling element (26) is generated as a stacked aluminum sheet structure, wherein the method furthermore comprises:
(d) arranging the nickel metal sheet (90, 90') on one of the aluminum sheets (24) which forms an outer side of the aluminum cooling element (26), wherein solder material is located between the nickel metal sheet (90) and the aluminum sheet (24), and wherein the solder material which is located between the nickel metal sheet (90) and the aluminum sheet (24) is melted by the heating procedure of step (c) to form a solder layer (36) between the nickel metal sheet (90, 90') and the aluminum cooling element (26) .

9. Method according to Claim 8, wherein, before the stacking procedure, at least one of the aluminum sheets (22) is punched to form a cooling channel by means of the surrounding aluminum sheets (20, 24) as a result of the stacking procedure.

10. Power circuit having a cooling element (10) according to one of Claims 1-7, wherein the power circuit furthermore has a printed circuit board (60) with a conductive layer (62, 64) on both sides, which printed circuit board is connected to the nickel metal sheet (90) by way of a solder layer (70), and wherein the power circuit furthermore has at least one semiconductor (80) which is mounted on the printed circuit board (60) on the side of the printed circuit board (60) which faces away from the nickel metal sheet (90).

11. Power circuit according to Claim 10, wherein the semiconductor (80) is a power semiconductor in the form of an unhoused semiconductor, which is mounted on the printed circuit board by means of a soft solder layer (62).

## Revendications

1. Dispositif de refroidissement (10), lequel possède un dissipateur thermique en aluminium (26) et au moins une pièce de tôle en nickel (90, 90'), laquelle est reliée au dissipateur thermique en aluminium (26) au moyen d'une couche de brasure (36), le dispositif de refroidissement (10) possédant une surface de fixation (92, 92') servant à la fixation et à l'absorption de chaleur d'au moins un semiconducteur ou d'un autre composant électrique ou électronique, laquelle est formée par un premier côté de la pièce de tôle en nickel (90) qui se trouve à l'opposé du dissipateur thermique en aluminium (26).

2. Dispositif de refroidissement selon la revendication 1, l'au moins une pièce de tôle en nickel (90, 90') étant reliée directement au dissipateur thermique en aluminium (26).

3. Dispositif de refroidissement selon la revendication 1 ou 2, le dissipateur thermique en aluminium (26) étant formé à partir de plusieurs tôles en aluminium (20, 22, 24) empilées les unes sur les autres et reliées les unes aux autres, au moins une tôle en aluminium (22) possédant des cavités (50) qui forment un canal de refroidissement qui est recouvert par au moins l'une des tôles en aluminium (20, 24).

4. Dispositif de refroidissement selon la revendication 3, les tôles en aluminium étant reliées les unes aux autres au moyen de couches de brasure (30, 32).

5. Dispositif de refroidissement selon la revendication 3 ou 4, les tôles en aluminium (20 à 24) étant des tôles en aluminium laminées qui peuvent être brasées par brasage fort.

6. Dispositif de refroidissement selon l'une des revendications précédentes, la pièce de tôle en nickel (90, 90') présentant une part massique de nickel d'au moins 70 %, de 85 % et de préférence d'au moins 95 %, 98 % ou 99 % de nickel, ou la pièce de tôle en nickel possédant un noyau métallique et une couche de nickel qui entoure celui-ci et qui présente une part massique de nickel d'au moins 70 %, de 85 % et de préférence d'au moins 95 %, 98 % ou 99 % de nickel.

7. Dispositif de refroidissement selon l'une des revendications précédentes, la pièce de tôle en nickel (90, 90') présentant une épaisseur d'au moins 200, 500 ou 800 µm.

8. Procédé de fabrication d'un dispositif de refroidissement (10) selon la revendication 1, comprenant :
(a) application de masse de brasure sur une surface d'assemblage d'au moins une tôle en aluminium (20, 22, 24) ;
(b) empilement des tôles en aluminium (20, 22, 24), lesquelles incluent l'au moins une tôle en aluminium sur laquelle a été appliquée la masse de brasure ;
(c) fusion de la masse de brasure afin de former au moins une couche de brasure (30, 32) entre les tôles en aluminium, en ce que les tôles en aluminium (20, 22, 24) sont réchauffes conjointement avec la masse de brasure, ce par quoi le dissipateur thermique en aluminium (26) est produit sous la forme d'une structure de tôles en aluminium empilées, le procédé comprenant en outre :
(d) arrangement de la pièce de tôle en nickel (90, 90') sur l'une des tôles en aluminium (24), laquelle forme un côté extérieur du dissipateur thermique en aluminium (26), la masse de brasure se trouvant entre la pièce de tôle en nickel (90) et la tôle en aluminium (24), et la masse de brasure qui se trouve entre la pièce de tôle en nickel (90) et la tôle en aluminium (24) étant mise en fusion par le réchauffement de l'étape (c) afin de former une couche de brasure (36) entre la pièce de tôle en nickel (90, 90') et le dissipateur thermique en aluminium (26).

9. Procédé selon la revendication 8, au moins l'une des tôles en aluminium (22) étant emboutie avant l'empilement afin de former par l'empilement un canal de refroidissement au moyen des tôles en aluminium (20, 24) environnantes.

10. Circuit de puissance comprenant un dissipateur thermique (10) selon l'une des revendications 1 à 7, le circuit de puissance possédant en outre un circuit imprimé (60) des deux côtés duquel se trouve une couche conductrice (62, 64), lequel et relié à la pièce de tôle en nickel (90) par le biais d'une couche de brasure (70), et le circuit de puissance possédant en outre au moins un semiconducteur (80) qui est monté sur le circuit imprimé (60), sur le côté du circuit imprimé (60) qui se trouve à l'opposé de la pièce de tôle en nickel (90).

11. Circuit de puissance selon la revendication 10, le semiconducteur (80) étant un semiconducteur de puissance sous la forme d'un semiconducteur sans boîtier qui est fixé sur le circuit imprimé au moyen d'une couche de brasure tendre (62).
